# EUROPEAN PATENT APPLICATION

(11) **EP 3 242 341 A1**
(43) Date of publication of application: **08.11.2017**
(21) Application number: 15839120.1
(22) Date of filing: 11.11.2015
(51) Int. Cl.: H01L 51/52, H01L 51/54, H01L 51/56, H01L 27/32, H01L 51/50

(54) **ARRAY SUBSTRATE AND MANUFACTURING METHOD THEREFOR, DISPLAY PANEL AND DISPLAY DEVICE**

(30) Priority: 31.12.2014 CN 201410855839
(71) Applicant: BOE Technology Group Co., Ltd., Beijing 100015 (CN)
(72) Inventor: FANG, Jingang, Beijing 100176 (CN); LI, Yanzhao, Beijing 100176 (CN); JIANG, Chunsheng, Beijing 100176 (CN); SHEN, Wulin, Beijing 100176 (CN)
(74) Representative: Cohausz & Florack
(86) International application number: PCT/CN2015/094281
(87) International publication number: WO 2016/107291

(57) **Abstract**

The present invention provides an array substrate and a method of fabricating the same, a display panel and a display device. The array substrate array substrate includes a thin film transistor and a zinc oxide layer provided above and/or below an active layer of the thin film transistor, and a vertical projection of the zinc oxide layer on the array substrate is at least overlapped with the vertical projection of the active layer on the array substrate. The zinc oxide layer has good absorption on UV light, so that adverse effects of UV light irradiation on a threshold voltage of the TFT of the array substrate are effectively avoided.

## Description

### FIELD OF THE INVENTION

The present invention relates to the field of display technology, and in particular to an array substrate and a method of fabricating the same, a display panel and a display device.

### BACKGROUND OF THE INVENTION

An OLED (Organic Light-Emitting Diode) display device mainly includes a TFT (Thin Film Transistor) array substrate and functional layers of the OLED. For the TFT array substrate, according to different materials of an active layer of the TFT, the TFT may be classified into an amorphous silicon (a-Si:H) TFT, a low temperature poly-silicon (referred to as LTPS) TFT, a high temperature poly-silicon (referred to as HTPS) TFT, an oxide TFT, and the like. Compared with the TFT of other types, the oxide TFT has the advantages of high electron mobility, good compatibility with a production line of display devices, and thus is the research hotspot in the current field.

The active layer is liable to generate a threshold voltage drift due to UV light irradiation, and taking the oxide TFT as an example, the active layer of the oxide TFT generally is made of IGZO (Indium Gallium Zinc Oxide), ITZO (Indium Tin Zinc Oxide), ZnO (zinc oxide), IZO (Indium Zinc Oxide) or the like. For a common IGZO OLED display device of a bottom gate structure, UV light will irradiate onto the IGZO active layer after being reflected by a cathode metal layer and a source/drain electrode metal layer for multiple times. Since a band gap of IGZO is about 3.4eV, the band gap of the UV light is higher than 3.1eV, and the IGZO has good absorption on the UV light, therefore after the irradiation of the UV light, valence-band electrons and electrons captured in a bandgap defect energy level in the active layer may easily absorb energy to jump to a conduction band to generate photo-generated electron-hole pairs, so as to drift a threshold voltage Vth of the TFT at last, thus resulting in abnormal gray scale display and a reduced image display effect.

### SUMMARY OF THE INVENTION

To overcome the defects in the prior art, the present invention provides an array substrate and a fabricating method thereof, a display panel and a display device, in order to solve the problem of TFT threshold voltage drift caused by UV light irradiation.

A first aspect of the present invention provides an array substrate, including a thin film transistor and a zinc oxide layer provided above and/or below an active layer of the thin film transistor, and a vertical projection of the zinc oxide layer on the array substrate is at least overlapped with the vertical projection of the active layer on the array substrate.

The zinc oxide layer may include a nanometer zinc oxide thin film.

A thickness range of the zinc oxide layer may be 5nm to 50nm.

The vertical projection of the zinc oxide layer on the array substrate may cover the vertical projection of the active layer on the array substrate.

The vertical projection of the zinc oxide layer on the array substrate may cover the entire array substrate.

The array substrate may further include: a passivation layer and a planarization layer which are provided above the active layer in sequence, and the zinc oxide layer is provided between the passivation layer and the planarization layer or above the planarization layer.

The array substrate may further include: a via hole provided above a drain electrode of the thin film transistor and penetrating through the planarization layer, the zinc oxide layer and the passivation layer.

The array substrate may further include: a buffer layer provided below the active layer, and the zinc oxide layer provided below the active layer of the thin film transistor is provided below the buffer layer.

The active layer may include indium gallium zinc oxide.

The array substrate may further include: an anode layer, a pixel defining layer, a light emitting layer and a cathode layer which are provided above the active layer.

The array substrate may further include: a color filter layer provided between the active layer and the anode layer.

A second aspect of the present invention provides a method for fabricating an array substrate, including: forming a thin film transistor, and forming a zinc oxide layer before and/or after forming an active layer of the thin film transistor, wherein a vertical projection of the zinc oxide layer on the array substrate is at least overlapped with the vertical projection of the active layer on the array substrate.

The step of forming the zinc oxide layer may include: forming a zinc layer; and annealing the formed zinc layer to oxidize the zinc layer to form the zinc oxide layer.

When annealing the zinc layer, the range of an annealing temperature may be 230°C to 400°C.

When forming the zinc layer, an evaporation process, a sputtering process or a deposition process may be adopted.

The zinc oxide layer may include a nanometer zinc oxide thin film.

A thickness range of the zinc oxide layer may be 5nm to 50nm.

The vertical projection of the zinc oxide layer on the array substrate may cover the vertical projection of the active layer on the array substrate.

The vertical projection of the zinc oxide layer on the array substrate may cover the entire array substrate.

The method may further include: forming a passivation layer and a planarization layer above the active layer in sequence, wherein the zinc oxide layer is formed between the passivation layer and the planarization layer or above the planarization layer.

The method may further include: after forming the planarization layer, the zinc oxide layer and the passivation layer, forming a via hole provided above a drain electrode of the thin film transistor and penetrating through the planarization layer, the zinc oxide layer and the passivation layer.

The method may further include: before forming the active layer of the thin film transistor, forming a buffer layer, and the step of forming the zinc oxide layer before forming the active layer of the thin film transistor includes: forming the zinc oxide layer before forming the buffer layer.

The method may further include: forming an anode layer, a pixel defining layer, a light emitting layer and a cathode layer above the active layer in sequence.

The method may further include: forming a color filter layer between the active layer and the anode layer.

A third aspect of the present invention provides a display panel, including the above array substrate.

A fourth aspect of the present invention provides a display device, including the above display panel.

In the array substrate and the method of fabricating the same, the display panel and the display device according to the present invention, the zinc oxide layer is formed above/below the active layer, so that the vertical projections of the zinc oxide layer and the active layer on the array substrate are overlapped, since the band gap of zinc oxide is 3.24eV, the zinc oxide has good absorption on UV light, so that the TFT threshold voltage drift caused by the irradiation of the UV light in the light rays on the active layer of the TFT may be avoided, and the stability of the TFT is improved.

### BRIEF DESCRIPTION OF THE DRAWINGS

To illustrate technical solutions in the embodiments of the present invention more clearly, a brief introduction on the accompanying drawings which are needed in the description of the embodiments is given below. Apparently, the accompanying drawings in the description below are merely some of the embodiments of the present invention, based on which other drawings may be obtained by those of ordinary skill in the art without any creative effort.

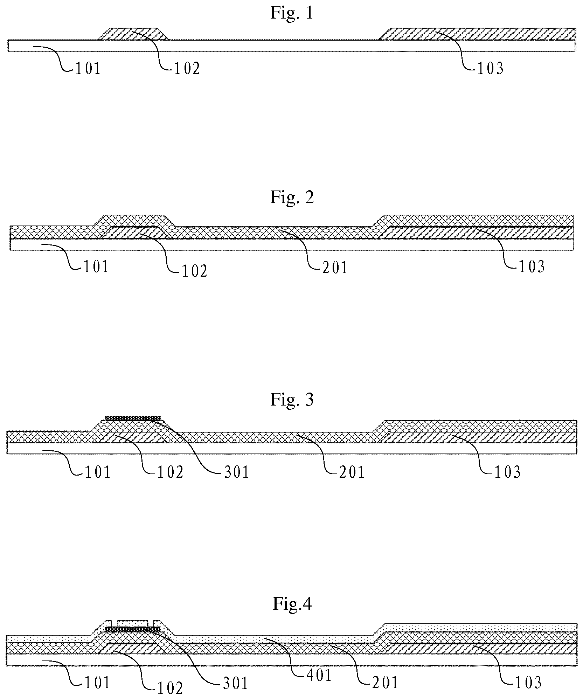

Fig. 1 to Fig. 14 are schematic diagrams of structures in steps of a method of fabricating a display panel according to the embodiments of the present invention.

### DETAILED DESCRIPTION OF THE EMBODIMENTS

In order that the purposes, features and advantages of the present invention are clearer, a clear and complete description of technical solutions in the embodiments of the present invention will be given below, in conjunction with the accompanying drawings in the embodiments of the present invention. Apparently, the embodiments described below are merely a part, but not all, of the embodiments of the present invention. All of other embodiments, obtained by those of ordinary skill in the art based on the embodiments of the present invention without any creative effort, fall within the protection scope of the present invention.

The embodiment of the present invention provides an array substrate, including a thin film transistor (TFT) and a zinc oxide layer provided above and/or below an active layer of the thin film transistor, and a vertical projection of the zinc oxide layer on the array substrate is at least overlapped with the vertical projection of the active layer on the array substrate. Since the band gap of zinc oxide is 3.24eV, the zinc oxide has good absorption on UV light, the vertical projections of the zinc oxide layer and the active layer on the array substrate are overlapped, so that the zinc oxide layer blocks irradiation of UV light on the active layer, accordingly, the condition of TFT threshold voltage drift caused by the irradiation of the UV light in the light rays on the active layer of the TFT may be avoided, and the stability of the TFT is improved.

In the embodiment, for example, the zinc oxide layer includes a nanometer zinc oxide thin film to further reinforce the absorption efficiency of the zinc oxide layer on the UV light. Of course, the zinc oxide layer may include an ordinary zinc oxide thin film (for example, a zinc oxide thin film formed by zinc oxide particles with diameters larger than a nanoscale), and this is not limited herein.

For example, a thickness range of the zinc oxide layer may be 5nm to 50nm, in order to guarantee sufficient absorption of the UV light without resulting in excessive increase on the overall thickness of the film layers on the array substrate.

To avoid the entire active layer from being irradiated by the UV light, for example, the vertical projection of the zinc oxide layer on the array substrate may cover the vertical projection of the active layer on the array substrate. For example, the vertical projection of the zinc oxide layer on the array substrate covers the entire array substrate, so that the effect of blocking UV light is better, and no separate patterning process is needed, the zinc oxide layer may be directly formed by sputtering, evaporation, deposition or other film forming processes, so that the process is simple and is easy to be achieved.

In the embodiment, the arrangement manner of the zinc oxide layer may be directionally designed according to different types of display panels. For an OLED display panel, most UV light irradiating on the TFT is from the upper side of the TFT, therefore the zinc oxide layer may be provided above the active layer. For a display panel of a liquid crystal type, a quite large part of UV light is from a backlight module on the back side of the array substrate, therefore the zinc oxide layer may be provided below the active layer. Of course, to simultaneously avoid the irradiation of the UV light from the upper side and the lower side of the TFT, the zinc oxide layers may be also provided on both of the upper side and the lower side of the active layer.

In the embodiment, the arrangement position of the zinc oxide layer in film layers of the array substrate is not limited. For example, the zinc oxide layer may be provided between two film layers with insulating property or above a film layer with the insulating property and is isolated from a film layer with conduction property, in order to avoid influence on the film layer with the conduction property.

Specifically, the zinc oxide layer may be provided above the active layer. For an array substrate of a bottom gate structure, a gate electrode, a gate electrode insulating layer, the active layer, a source/drain electrode metal layer, a passivation layer and a planarization layer are sequentially provided on a substrate, the film layer with the insulating property above the active layer includes the passivation layer and the planarization layer, and for example, the zinc oxide layer may be provided between the passivation layer and the planarization layer or above the planarization layer. If the array substrate further includes a via hole for exposing the source/drain electrode metal layer, the via hole penetrates through the planarization layer, the zinc oxide layer and the passivation layer to expose the source/drain electrode metal layer, so that an electrode formed in a subsequent step may be electrically connected with the source/drain electrode metal layer through the via hole. In addition, for an array substrate of a top gate structure, the active layer, the source/drain electrode metal layer, the gate electrode insulating layer, the gate electrode, the passivation layer and the planarization layer are sequentially provided on the substrate, the film layer with the insulating property above the active layer includes the passivation layer and the planarization layer, for example, the zinc oxide layer may be provided between the passivation layer and the planarization layer or above the planarization layer. If the array substrate further includes the via hole for exposing the source/drain electrode metal layer, the via hole penetrates through the planarization layer, the zinc oxide layer and the passivation layer, so that the electrode formed in the subsequent step may be electrically connected with the source/drain electrode metal layer through the via hole.

In addition, the zinc oxide layer may be provided below the active layer, and since a buffer layer may be provided below the active layer, the zinc oxide layer may be provided below the buffer layer.

Of course, for the array substrates with different structures, the zinc oxide layer may also be provided in other arrangement manners and arrangement positions excluding the arrangement manners and arrangement positions listed above, which will not be listed one by one herein.

In addition, it should be noted that, the material of the active layer of the array substrate in the embodiment may be an indium gallium zinc oxide. The indium gallium zinc oxide has relatively high electron mobility, but is sensitive to UV light, thereby being prone to the influence of the UV light to generate a threshold voltage drift problem. In the embodiment, since the zinc oxide layer used for blocking the UV light is provided, the threshold voltage drift problem when the indium gallium zinc oxide is used as the active layer is solved, thus the technical solution provided by the embodiment is particularly suitable for the array substrate using the indium gallium zinc oxide as the active layer.

It should be noted that, for a display device of an OLED type, the array substrate provided by the embodiment may further include: an anode layer, a pixel defining layer, a light emitting layer and a cathode layer, and the anode layer may be electrically connected with the source/drain electrode metal layer of the TFT on the array substrate through a via hole. The array substrate may further include: a hole injection layer, a hole transport layer, an electronic transport layer and an electronic injection layer, and the light emitting layer is provided between the hole transport layer and the electronic transport layer. The hole injection layer, the hole transport layer, the light emitting layer, the electronic transport layer and the electronic injection layer constitute functional layers of the OLED, and the functional layers are provided between the anode layer and the cathode layer. Further, if the light rays generated by the light emitting layer are white light, the array substrate may further include a color filter layer provided between the active layer and the anode layer, in order to filter the white light generated by the light emitting layer and make the light passing by sub-pixels respectively have a single color such as red, green, blue, yellow or the like. In addition, if the light emitting layers of different sub-pixels may emit the light with respective single colors such as red, green, blue, yellow or the like, the color filter layer does not need to be provided.

For a display device of a liquid crystal type, the array substrate provided by the embodiment may further include an electrode which is electrically connected with the source/drain electrode metal layer of the TFT on the array substrate through a via hole, and the electrode may be specifically a pixel electrode.

The embodiment further provides a method for fabricating an array substrate, comprising: forming a thin film transistor; and forming a zinc oxide layer before and/or after forming an active layer of the thin film transistor, wherein a vertical projection of the zinc oxide layer on the array substrate is at least overlapped with the vertical projection of the active layer on the array substrate. Since the band gap of zinc oxide is 3.24eV, the zinc oxide has good absorption on UV light, and the vertical projection of the zinc oxide layer on the array substrate is overlapped with the vertical projection of the active layer on the array substrate, so that the zinc oxide layer blocks UV light from irradiating on the active layer, TFT threshold voltage drift caused by the irradiation of the UV light on the active layer of the TFT is avoided, and the stability of the TFT is improved.

For example, in the embodiment, the method for forming the zinc oxide layer may include: forming a zinc layer, wherein the vertical projection of the zinc layer on the array substrate is at least overlapped with the vertical projection of the active layer on the array substrate; and annealing the formed zinc layer to oxidize the zinc layer to form the zinc oxide layer. The foregoing method for forming the zinc oxide layer has low process requirements, thereby being easy to be achieved.

The method for fabricating the array substrate according to the embodiment is varied according to different structures of the manufactured array substrate. For example, for the array substrate including a thin film transistor of a bottom gate structure, in which the zinc oxide layer is provided above the active layer, the method may further include: after forming the active layer, forming a passivation layer and a planarization layer above the active layer in sequence, wherein the zinc oxide layer is formed between the passivation layer and the planarization layer or above the planarization layer. The method may further include: after forming the planarization layer, the zinc oxide layer and the passivation layer, forming a via hole penetrating through the planarization layer, the zinc oxide layer and the passivation layer, so that an electrode formed in a subsequent step may be electrically connected with a source/drain electrode metal layer through the via hole. In addition, for the array substrate including a thin film transistor of a top gate structure, in which the zinc oxide layer is provided above the active layer, the method may further include: after forming the active layer, forming the source/drain electrode metal layer, a gate electrode insulating layer, a gate electrode, the passivation layer and the planarization layer above the active layer in sequence, wherein the zinc oxide layer is formed between the passivation layer and the planarization layer or above the planarization layer. The method may further include: after forming the planarization layer, the zinc oxide layer and the passivation layer, forming a via hole penetrating through the planarization layer, the zinc oxide layer and the passivation layer, so that the electrode formed in the subsequent step may be electrically connected with the source/drain electrode metal layer through the via hole. In addition, for the array substrate in which the zinc oxide layer is provided below the active layer, the method may further include: before forming the active layer, forming a buffer layer, wherein the zinc oxide layer is formed below the buffer layer, namely, the zinc oxide layer is formed on the substrate before the buffer layer is formed.

The method of fabricating the array substrate including the thin film transistor of the bottom gate structure, in which the zinc oxide layer is provided between the passivation layer and the planarization layer, will be introduced below in detail in conjunction with Fig. 1 to Fig. 14.

In step S1, a pattern including a gate electrode 102 is formed on a substrate 101, as shown in Fig. 1.

In the step, for example, the substrate 101 may be a transparent substrate, and corning glass, Asahi glass or quartz glass and the like may be specifically adopted to guarantee subsequent processes and enough mechanical strength of the display device. For example, a thickness range of the substrate 101 may be 50µm to 1000µm, in order to meet the demands of display devices with various thicknesses.

For example, the material of the pattern including the gate electrode 102 may be Al, Mo, Cr, Cu, Ti or other metals, in order to guarantee good conductivity of the gate electrode 102. The thickness of the pattern may be designed according to actual conditions and demands, for example, the thickness range may be 200nm to 1000nm.

The step of preparing the pattern including the gate electrode 102 may include: forming a material layer of the gate electrode 102 on the substrate 101 by adopting a sputtering or deposition process; defining photoresist with the pattern including the gate electrode 102 on the material layer by adopting a patterning process, and etching the material layer by dry etching or wet etching to form the necessary pattern including the gate electrode 102; and stripping off the photoresist. In the patterning process, the accuracy of the position and the size of the pattern is guaranteed. In addition, when forming the gate electrode 102, a metal element 103 may be formed in the same layer as the gate electrode 102, and the metal element 103 formed in the same layer as the gate electrode 102 may be used as a capacitor electrode, a via hole connecting layer, a gate line, a common electrode wire, etc.

In step S2, a gate electrode insulating layer 201 is formed on the substrate 101 formed with the pattern including the gate electrode 102, as shown in Fig.2.

The thickness range of the gate electrode insulating layer 201 may be 50nm to 500nm, preferably 100nm to 300nm, to guarantee good insulating property between the gate electrode 102, the via hole connecting layer 103 and other subsequently formed conductive film layers. For example, the gate electrode insulating layer 201 may be made of at least one organic or inorganic material of SiOx (silicon oxide, for example, SiO₂), SiNx (silicon nitride, for example, Si₃N₄), SiOxNy (silicon oxynitride) and the like, and may be further formed into a single-layer or multilayer thin film structure to well protect the film layers above or below thereto.

In the step, the gate electrode insulating layer 201 may be formed by a CVD (Chemical Vapor Deposition), and particularly a PECVD (Plasma Enhanced Chemical Vapor Deposition) process.

In step S3, a pattern including an active layer 301 is formed on the gate electrode insulating layer 201, as shown in Fig. 3.

For example, the material of the active layer 301 may be IGZO, ITZO or other oxide semiconductors, so that the TFT has higher electron mobility. For example, the thickness range of the active layer 301 may be 5nm to 250nm to guarantee good electrical property for the active layer.

The step of forming the pattern including the active layer 301 may include: covering an active layer material on the gate electrode insulating layer 201 by adopting the sputtering or deposition process; and etching the covered active layer material by adopting the patterning process to form the pattern including the active layer 301. The active layer 301 is specifically provided in an area above the gate electrode 102.

In step S4, an etch stop layer 401 is formed on the substrate 101 formed with the pattern including the active layer 301, a source electrode contact hole and a drain electrode contact hole for exposing the surface of the active layer 301 are provided in the etch stop layer 401, as shown in Fig. 4.

In the step, for example, the etch stop layer 401 may be a SiOx thin film with a thickness ranging from 50nm to 200nm.

The step of forming the etch stop layer 401 may include: depositing etch stop layer material by adopting the PECVD process at first; and then defining patterns of the source electrode contact hole and the drain electrode contact hole by the patterning process, and etching the etch stop layer material until the surface of the active layer 301 is exposed.

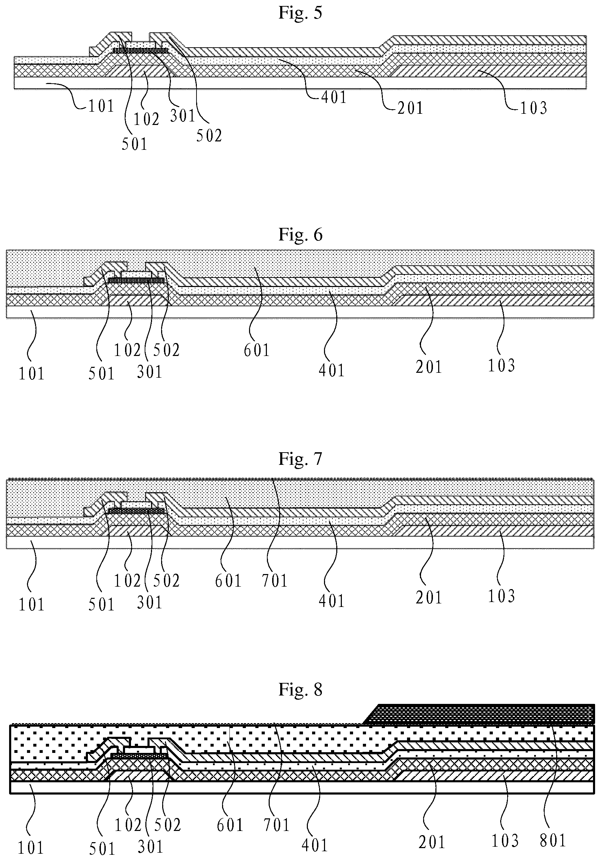

In step S5, a pattern including a drain electrode 501 and a source electrode 502 is formed on the etch stop layer 401, the source electrode 502 is electrically connected with the active layer 301 through the source electrode contact hole, and the drain electrode 501 is electrically connected with the active layer 301 through the drain electrode contact hole, as shown in Fig. 5.

In the step, for example, the thickness range of the pattern including the drain electrode 501 and the source electrode 502 may be 5nm to 250nm, and the material of the pattern may be Al, Mo, Cr, Cu, Ti or other metals to guarantee small transmission resistance of the drain electrode 501 and the source electrode 502.

For example, the pattern formed in the same layer as the drain electrode 501 and the source electrode 502 may further include a connecting metal layer, which is used for electrically connecting the source electrode of a switching transistor with the gate electrode of a driving transistor in a pixel of the display device. In addition, the pattern formed in the same layer may further include a data line, and the data line is electrically connected with the source electrode 502 for applying a data voltage signal to the pixel.

The step of forming the pattern including the drain electrode 501 and the source electrode 502 may include: covering a source/drain electrode metal material by adopting the sputtering or deposition process; and then defining the patterns of the drain electrode 501 and the source electrode 502 by the patterning process, and etching the source/drain electrode metal material to form the pattern including the drain electrode 501 and the source electrode 502. After the step, the TFT of the OLED display device is prepared.

In step S6, a passivation layer 601 is formed on the substrate 101 formed with the pattern including the drain electrode 501 and the source electrode 502, as shown in Fig. 6.

In the step, for example, the passivation layer 601 may be formed by insulating materials such as silicon oxide, silicon nitride and other inorganic materials and organic materials, and the passivation layer 601 may repair defects on the surface of an adjacent film layer and defects in the adjacent film layer (for example, the pattern including the drain electrode 501 and the source electrode 502), in order to improve the quality of the thin film.

For example, the passivation layer 601 may be prepared by the PECVD process.

In step S7, a zinc oxide layer 701 is formed on the passivation layer 601, as shown in Fig. 7.

Specifically, the step of forming the zinc oxide layer 701 may include: forming a zinc layer on the passivation layer 601, wherein the vertical projection of the zinc layer on the substrate 101 is at least overlapped with the vertical projection of the active layer 301 on the substrate 101; and annealing the substrate 101 formed with the zinc layer to oxidize the zinc layer to form the zinc oxide layer 701.

The band gap of zinc oxide is 3.24eV, thereby having a good UV light absorption effect, and thus the zinc oxide layer 701 may well prevent a TFT electrical property deterioration problem caused by the irradiation of the UV light on the active layer 301 of the TFT.

In the prior art, the influence of UV light irradiation on TFTs in the display device is relieved by a solution of forming an electrode capable of reflecting the UV light on the passivation layer or the active layer by adopting the patterning process. However, since the patterning process requires a plurality of steps of coating, alignment, exposure, development, cleaning and the like, and the cost of the patterning process is high, this will undoubtedly increase the complexity and the fabricating cost of the entire fabricating process of the display device. In the step, only two steps of forming the zinc layer and annealing oxidation are necessary for forming the zinc oxide layer, and the complex and expensive patterning process is unnecessary, so that the process is simple and feasible, and the cost is low.

In the step, for example, the zinc layer may be a thin film formed of nanometer zinc particles, preferably, may be a thin film made of uniformly distributed nanometer zinc particles, so that the zinc oxide layer 701 formed by oxidization is a nanometer zinc oxide thin film, in order to guarantee a higher UV light absorption effect.

For example, the thickness range of the zinc layer may be 5nm to 50nm, so that the thickness range of the zinc oxide layer 701 formed by oxidization is 5nm to 50nm to guarantee higher light transmittance of the display device.

The zinc layer may cover the active layer 301, so that the zinc oxide layer 701 formed by oxidization may cover the active layer 301 to more effectively prevent the UV light from irradiating the active layer.

It should be noted that, if a solution of adhering an anti-UV protective film on the outer side of the array substrate is adopted, to guarantee an ideal UV absorption effect, a larger thickness of the anti-UV protective film should be set, and this influences the light transmittance of the array substrate to a certain extent. In the embodiment, since the zinc oxide has good UV light absorption effect, an ideal UV blocking effect may be achieved with a relatively thin zinc oxide layer. A thickness of the zinc layer may be set to be very small, so that the light transmittance of the array substrate manufactured in the embodiment is higher.

In addition, it should be noted that, the particle diameters of zinc particles are merely nanometers, so that the formed zinc layer is denser, and then the subsequently formed zinc oxide layer is denser, in this way, on the premise of the same UV light absorption effect, a thinner zinc layer formed by the nanometer zinc particles may be fabricated, which further improves the light transmittance of the device.

For example, in the step of forming the zinc layer, the evaporation process, the sputtering process or the deposition process may be adopted to guarantee the uniformity of the thicknesses of the zinc layer and the zinc oxide layer 701.

Since the oxidizing temperature of zinc is very low, zinc may be acutely oxidized at 225°C in general, therefore in the step, the necessary annealing temperature is very low, and this may further reduce the process difficulty. For example, when forming the zinc layer, the range of the annealing temperature used for annealing the substrate may be 230°C to 400°C to guarantee the full oxidization of the zinc layer and improve the UV absorption effect of the zinc oxide layer 701. Since the annealing temperature is very low, the method of fabricating the OLED display device may be further simplified, and the production cost is reduced.

In step S8, a color filter layer material is spin coated, and a color filter layer 801 is formed by adopting the patterning process, as shown in Fig. 8.

For example, the color filter layer material may be resin of three colors: red (R), green (G) and blue (B), or resin of four colors: red, green, blue and white (W), to achieve full-color display of the OLED display device. For example, the thickness range of the color filter layer 801 may be 2µm to 3.5µm and may be correspondingly designed according to actual demands.

The vertical projection of the color filter layer 801 is provided in a grid formed by gate lines and data lines intersected with each other.

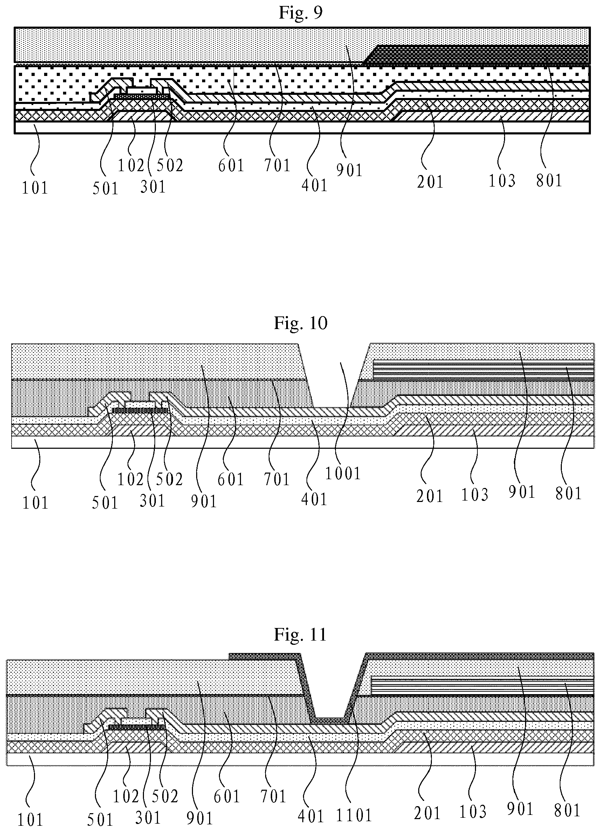

In step S9, a planarization layer material is spin coated, and the planarization layer 901 is formed by adopting the patterning process, as shown in Fig. 9.

In the step, the thickness range of the planarization layer 901 is 1µm to 2µm, and the planarization layer material may be resin to guarantee surface planarization of the substrate 101 formed with the color filter layer 801.

In step S10, a via hole 1001 penetrating through the planarization layer 901, the zinc oxide layer 701 and the passivation layer 601 in sequence is formed by adopting the patterning process, as shown in Fig. 10.

In the step, for example, the via hole 1001 may be composed of a planarization layer via hole penetrating through the planarization layer 901 and a passivation layer via hole penetrating through the zinc oxide layer 701 and the passivation layer 601, and the aperture of the planarization layer via hole is larger than that of the passivation layer via hole to improve the thin film quality of the anode formed in the via hole 1001 subsequently and reinforce the conductivity of the anode.

For example, the step of forming the via hole 1001 may include: exposing and developing an area to be formed with the planarization layer via hole on the planarization layer 901 by adopting the patterning process to form the planarization layer via hole for exposing the zinc oxide layer 701; and then forming a photoresist layer with a passivation layer via hole pattern in an area to be formed with the passivation layer via hole by adopting the patterning process, and etching the zinc oxide layer 701 and the passivation layer 601 with the photoresist layer as a mask, until the surface of the pattern including the source electrode 502 and the drain electrode 501 is exposed (namely, the surface of the connecting metal layer is exposed), to form the passivation layer via hole, and the passivation layer via hole and the planarization layer via hole constitute the via hole together.

In the above step, since the zinc oxide layer 701 is formed between the passivation layer 601 and the color filter layer 801, the via hole 1001, which is formed after the planarization layer 901 is formed, sequentially penetrates through the planarization layer 901, the zinc oxide layer 701 and the passivation layer 601.

It should be noted that, the embodiment only describes the method of forming the zinc oxide layer 701 between the passivation layer 601 and the planarization layer 901 in detail. In other embodiments of the present invention, the zinc oxide layer may also be formed after the planarization layer is formed, the specific process may be obtained by correspondingly modifying the fabricating method provided by the embodiment, and will not be described herein in detail. It should be noted that, if the zinc oxide layer is formed after the planarization layer is formed, the via hole, which is formed after the zinc oxide layer is formed, sequentially penetrates through the zinc oxide layer, the planarization layer and the passivation layer. In this case, the step of forming the via hole may specifically include: after forming the zinc oxide layer, forming the planarization layer via hole penetrating through the zinc oxide layer and the planarization layer by adopting the patterning process; and then forming the passivation layer via hole penetrating through the passivation layer by adopting the patterning process, and the passivation layer via hole and the planarization layer via hole constitute the via hole together.

In step S11, an anode layer 1101 is formed on the planarization layer 901 in the via hole 1001 and above the color filter layer 801, as shown in Fig. 11.

A part of the anode layer 1101 is electrically connected with the connecting metal layer through the via hole 1001, since the connecting metal layer is connected with the source electrode 502 of the TFT, the anode layer 1101 is electrically connected with the source electrode 502 to be applied with a certain voltage when the TFT is turned on. The other part of the anode layer 1101 is provided above the color filter layer 801 to serve as the pixel electrode of the device.

For example, the thickness range of the anode layer 1101 may be 10nm to 100nm, and the material of the anode layer 1101 may be transparent conductive materials such as ITO (Indium Tin Oxide), etc.

In the step, for example, a transparent conductive thin film is deposited on the substrate 101 formed with the via hole 1001 by adopting the sputtering process, in order to form the anode layer 1101.

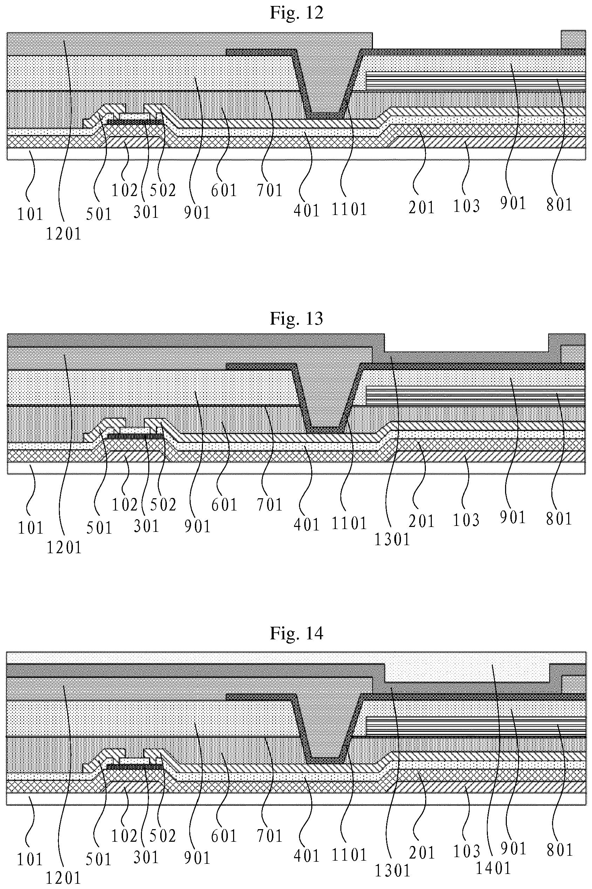

In step S12, a pixel defining layer 1201 is formed on the substrate 101 formed with the anode layer 1101, as shown in Fig. 12.

The pixel defining layer 1201 has a pattern of a pixel opening area, and the pixel defining layer 1201 is used for defining an opening area of the pixel of the display device.

For example, the thickness range of the pixel defining layer 1201 may be 1µm to 2µm, the thickness thereof may be specifically equal to the thickness of the subsequently formed OLED, and the material of the pixel defining layer 1201 may be an organic material, so that the anode layer 1101 provided in an non-opening area is kept to be insulated from other film layers when defining the opening area.

The step of forming the pixel defining layer 1201 may include: applying the organic material of the pixel defining layer 1201 to cover the substrate by adopting a spin coating process; and removing the pixel defining layer material corresponding to the opening area by a photolithographic process to form the pixel defining layer 1201 with a necessary pattern.

In step S 13, functional layers 1301 of the OLED are formed on the substrate 101 formed with the pixel defining layer 1201, as shown in Fig. 13.

For example, in one embodiment, the functional layers 1301 of the OLED may include the following layers along a direction from being close to the substrate 101 to being away from the substrate 101: a hole transport layer, a light emitting layer and an electronic transport layer. In another embodiment, the functional layers 1301 of the OLED may include the following layers along the direction from being close to the substrate 101 to being away from the substrate 101: a hole injection layer, the hole transport layer, the light emitting layer, the electronic transport layer and an electronic injection layer. The hole transport layer may adopt NPB (N, N'-diphenyl-N-N' di(1-naphthyl)-1, 1' diphenyl-4, 4'-diamine) with thickness of 50nm. The main material of the light emitting layer may be a doped phosphorescent material with thickness of 25nm, the light emitting layer for emitting red light adopts CBP:Btp2Ir(acac), the light emitting layer for emitting green light adopts CBP:(ppy) 2Ir(acac), and the light emitting layer for emitting blue light adopts CBP:FIrpic. The electronic transport layer may adopt Bphen with thickness of 25nm.

For example, the functional layers 1301 of the OLED may be formed by thermal evaporation deposition in an organic metal thin film deposition high vacuum system, the vacuum degree in the evaporation process may be 1×10⁻⁵Pa, the evaporation temperature of the hole transport layer and the light emitting layer may be 170°C, and the evaporation temperature of the electronic transport layer may be 190°C.

In step S14, a cathode layer 1401 may be formed on the functional layers 1301 of the OLED, as shown in Fig. 14.

In the step, for example, the material of the cathode layer 1401 may be Ag, Mg or other metal materials with high reflectivity, the thickness range of the cathode layer 1401 may be 10nm to 100nm to reflect light emitted from the upper side towards the direction of the substrate 101, so as to improve the utilization rate of the light.

For example, the cathode layer 1401 may be formed by the evaporation process, and the evaporation temperature may be about 900°C.

It should be noted that, the array substrate formed in the above step S1 to the step S 14 is an array substrate suitable for the display device of the OLED type, the light generated by the light emitting layer thereof is white light, and to achieve full-color luminescence, the color filter layer 801 needs to be formed in the step S8. In other embodiments of the present invention, if the light emitting layer may respectively emit light with a single color such as red, green, blue, yellow or the like, the step S8 may be omitted, and the color filter layer 801 does not need to be provided. On the other hand, the array substrate formed in the embodiment is in a bottom light emission type, those skilled in the art may obtain an array substrate of a top light emission type by corresponding modifying the fabricating method in the embodiment. On the other hand, the TFT of the array substrate formed in the embodiment is provided with a bottom gate and ESL (Etch Stop Layer) structure, in other embodiments of the present invention, the TFT of the array substrate may also adopt a top gate and BCE (Back Channel Etching) structure, etc. On the other hand, the fabricating method provided by the embodiment may be modified, for example, the TFT and related structures thereof are formed by the above step S1 to the step S10, and after the step S10, the pixel electrode electrically connected with the source/drain electrode metal layer through the via hole is formed to obtain an array substrate suitable for the display device of the liquid crystal type.

The embodiment further provides a display panel, including the array substrate provided by the foregoing embodiment. Since the stability of the TFT of the array substrate contained in the display panel is high, the display panel has the advantage of good display image quality.

The display panel provided by the embodiment may be a liquid crystal type or may also be an OLED type.

The embodiment further provides a display device, including the display panel provided by the foregoing embodiment, and the display device has the advantage of good display quality. The OLED display device in the embodiment may be any product or component having a display function, such as a mobile phone, a tablet computer, a TV set, a display, a notebook computer, a digital photo frame, a navigator, etc.

The foregoing descriptions are merely specific embodiments of the present invention, rather than limiting the protection scope of the present invention. Any skilled one who is familiar with this art could readily think of variations or substitutions within the disclosed technical scope of the present invention, and these variations or substitutions shall fall within the protection scope of the present invention. Accordingly, the protection scope of the present invention is defined by the claims.

## Claims

1. An array substrate, comprising:
a thin film transistor; and
a zinc oxide layer provided above and/or below an active layer of the thin film transistor,
wherein a vertical projection of the zinc oxide layer on the array substrate is at least overlapped with the vertical projection of the active layer on the array substrate.

2. The array substrate of claim 1, wherein the zinc oxide layer comprises a nanometer zinc oxide thin film.

3. The array substrate of claim 1, wherein the zinc oxide layer has a thickness ranging from 5nm to 50nm.

4. The array substrate of claim 1, wherein the vertical projection of the zinc oxide layer on the array substrate covers the vertical projection of the active layer on the array substrate.

5. The array substrate of claim 4, wherein the vertical projection of the zinc oxide layer on the array substrate covers the entire array substrate.

6. The array substrate of claim 1, further comprising: a passivation layer and a planarization layer which are provided above the active layer in sequence, wherein the zinc oxide layer is provided between the passivation layer and the planarization layer or above the planarization layer.

7. The array substrate of claim 6, further comprising: a via hole provided above a drain electrode of the thin film transistor and penetrating through the planarization layer, the zinc oxide layer and the passivation layer.

8. The array substrate of claim 1, further comprising: a buffer layer provided below the active layer, wherein the zinc oxide layer provided below the active layer of the thin film transistor is provided below the buffer layer.

9. The array substrate of any one of claims 1-8, wherein the active layer comprises an indium gallium zinc oxide.

10. The array substrate of any one of claims 1-8, further comprising: an anode layer, a pixel defining layer, a light emitting layer and a cathode layer which are provided above the active layer.

11. The array substrate of claim 10, further comprising: a color filter layer provided between the active layer and the anode layer.

12. A method for fabricating an array substrate, comprising:
forming a thin film transistor; and
forming a zinc oxide layer before and/or after forming an active layer of the thin film transistor, wherein a vertical projection of the zinc oxide layer on the array substrate is at least overlapped with the vertical projection of the active layer on the array substrate.

13. The method of claim 12, wherein forming the zinc oxide layer comprises:
forming a zinc layer; and
annealing the formed zinc layer to oxidize the zinc layer to form the zinc oxide layer.

14. The method of claim 13, wherein an annealing temperature ranges from 230°C to 400°C when annealing the zinc layer.

15. The method of claim 13, wherein an evaporation process, a sputtering process or a deposition process is adopted when forming the zinc layer.

16. The method of claim 12, wherein the zinc oxide layer comprises a nanometer zinc oxide thin film.

17. The method of claim 12, wherein the zinc oxide layer has a thickness ranging from 5nm to 50nm.

18. The method of claim 12, wherein the vertical projection of the zinc oxide layer on the array substrate covers the vertical projection of the active layer on the array substrate.

19. The method of claim 18, wherein the vertical projection of the zinc oxide layer on the array substrate covers the entire array substrate.

20. The method of claim 12, further comprising: forming a passivation layer and a planarization layer above the active layer in sequence, wherein the zinc oxide layer is formed between the passivation layer and the planarization layer or above the planarization layer.

21. The method of claim 20, further comprising: after forming the planarization layer, the zinc oxide layer and the passivation layer, forming a via hole provided above a drain electrode of the thin film transistor and penetrating through the planarization layer, the zinc oxide layer and the passivation layer.

22. The method of claim 12, further comprising: before forming the active layer of the thin film transistor, forming a buffer layer, wherein
forming the zinc oxide layer before forming the active layer of the thin film transistor comprises: forming the zinc oxide layer before forming the buffer layer.

23. The method of any one of claims 12-22, further comprising: forming an anode layer, a pixel defining layer, a light emitting layer and a cathode layer above the active layer in sequence.

24. The method of claim 23, further comprising: forming a color filter layer between the active layer and the anode layer.

25. A display panel, comprising the array substrate of any one of claims 1-11.

26. A display device, comprising the display panel of claim 25.
